Europäisches Patentamt

European Patent Office

Office européen des brevets

(11) Publication number: **0 032 626**
**B1**

# EUROPEAN PATENT SPECIFICATION

(45) Date of publication of patent specification: **03.07.85**

(21) Application number: **80304615.0**

(22) Date of filing: **19.12.80**

(51) Int. Cl.⁴: **G 11 C 11/34,** **H 01 L 27/10,**
**H 01 L 27/14, G 11 C 11/24**

(54) **A semiconductor device.**

(30) Priority: **27.12.79 JP 170782/79**

(43) Date of publication of application:
**29.07.81 Bulletin 81/30**

(45) Publication of the grant of the patent:
**03.07.85 Bulletin 85/27**

(84) Designated Contracting States:
**DE FR GB NL**

(56) References cited:
**US-A-3 979 734**

**IBM TECHNICAL DISCLOSURE BULLETIN,
vol.16, no.10, March 1974, New York (US), W.P.
Noble: "Bulk access-surface storage memory
cells" pages 3170 - 3172**

**ELECTRONICS, vol.51, no.26, December 21,
1978, New York (US) "Simple cell design for
dynamic RAM scraps capacitor", pages 31-32**

**IEEE JOURNAL OF SOLID STATE CIRCUITS,
vol.SC-11, no.1, February 1976, New York (US)
P.G.A. JESPERS et al: "Three-terminal charge-
injection device" pages 133-139.**

(73) Proprietor: **FUJITSU LIMITED
1015, Kamikodanaka Nakahara-ku
Kawasaki-shi Kanagawa 211 (JP)**

(72) Inventor: **Togei, Ryoiku
23-6, Narusedai 2-chome Machida-shi
Tokyo 194 (JP)**

(74) Representative: **Sunderland, James Harry et al
HASELTINE LAKE & CO Hazlitt House 28
Southampton Buildings Chancery Lane
London WC2A 1AT (GB)**

(56) References cited:
**P. RICHMAN: "MOS FIELD-EFFECT
TRANSISTORS AND INTEGRATED CIRCUITS",
1973, John Wiley & Sons, New York, London,
Sydney, Toronto "The capacitance of a MOS
structure as a function of a voltage and
frequency" pages 47-72.**

Courier Press, Leamington Spa, England.

## Description

The present invention relates to a semiconductor device.

Customarily, random access memory cells fail into two categories:— the static type and the dymamic type. The former type is, in general terms, based on flip-flop circuits and inevitably has drawbacks inherent in flip-flop circuits. Namely, a fairly large area of a semiconductor chip is required for production of a memory cell, and a relatively large amount of electric power is required to sustain information in a memory cell. The latter type is, in general terms, based on a combination of gate transistors and capacitors. Since capacitors formed in semiconductor chips for memory cells are more or less volatile, any type of dynamic memory cell requires refresh circuitry, albeit that less electric power is required to sustain information. Further, information memorized in a dynamic memory cell is destroyed, when it is read out. In other words, dynamic memory cells are subject to destructive read out.

IBM Technical Disclosure Bulletin, Vol. 16, No. 10, March 1974, in an article entitled "BULK ACCESS-SURFACE STORAGE MEMORY CELLS" by W. P. Noble, Jr., on pages 3170 to 3172, discloses a memory device having an array of memory cells, located at the intersections of word lines and bit lines, which employ charge storage for holding information.

According to the present invention there is provided a semiconductor device having:

a substrate of a material which is either an insulator or a semiconductor of one conductivity type;

a matrix array of memory cells, each memory cell comprising:—

a semiconductor charge source region formed on a selected portion of said substrate and, in a case in which the substrate is of a semiconductor of one conductivity type, having a conductivity type different from that of the substrate,

a semiconductor charge storage region, having a conductivity type different from that of said charge source region, formed on a selected portion of said charge source region, and being electrically floating on said substrate, a P-N junction being formed between the charge storage region and the charge source region,

an insulating layer formed on said charge storage region and the top surface of said charge source region which is not covered by said charge storage region, and

a conductor layer formed on said insulating layer;

bit lines, each constituted by the respective conductor layers of a plurality of the memory cells arranged one after another along a respective row of the matrix array, together with conductor zones connecting those conductor layers; and

word lines, each constituted by the respective charge source regions of a plurality of the memory cells arranged one after another along a respective column of the matrix array together with buried conductor regions connecting those charge source regions.

An embodiment of the this invention can provide a semiconductor device which functions as a random access memory cell and which is based on a concept different from either of those on which the two categories of conventional random access memory cell are based. In an embodiment of this invention a memory cell consists of only one capacitor of which the capacity varies depending on whether or not a bit of information is memorized therein. The memory cell requires only a fairly small area of semiconductor chip for its production and can offer non-destructive read out.

An embodiment of this invention can provide a semiconductor device which functions as a photo-electric transducer unit, for example as an image sensor unit, based on the same concept as the above-mentioned memory cell embodiment of the invention.

An embodiment of this invention can provide an image sensor utilizing a plurality of photo-electric transducer units or image sensor units as mentioned above.

In a random access memory cell of a semiconductor device embodying this invention address signals are applied to the charge source region when the device is in use, and data signals are applied to the conductor layer of the cell when the device is in use.

In the above-mentioned device, a capacitor is constituted between the charge source region and the conductor layer. Since the charge storage region is interleaved or interposed between the charge source region and the insulating layer and some quantity of electric charge is allowed to be stored in the charge storage region, the capacity of the capacitor varies depending on whether or not the charge storage region is filled with charge. This is a phenomenon which can be utilized for memorizing electric signals. In other words, when an electric pulse signal which is of a polarity such that it can pass through the P-N junction is applied to the charge source region, some quantity of electric charge is stored and confined in the charge storage region, as a result decreasing the capacity of the capacitor. This change in capacity is utilized as a parameter or effect for memorizing information. Not only minority carriers but majority carriers also can be stored in the charge storage region, depending on specific operating conditions. When reading out information, an electric voltage pulse signal with a polarity the reverse of that which was employed for writing information is applied to the conductor layer. Depending on whether information is written or not, this reverse polarity pulse signal causes a current to flow or no current to flow.

To provide a photo-electric transducer unit or an image sensor unit in a device embodying this invention the conductor layer of a memory cell is formed of a transparent conductive material such as tin oxide ($SnO_2$).

In such a case, when the charge source region covered by the charge storage region and further covered by the transparent conductor layer is irradiated with light (radiation), the charge storage region can be filled with electric charges, as a result changing the capacity of the capacitor on the basis of the same function as is effective for the above described memory cell, this change in capacity can be utilized to memorize information given in the form of light or radiation. Information reading procedure is the same as that mentioned above for a memory cell. Namely, when a voltage pulse signal of a polarity the same as the conductivity type of the charge source region is applied to the conductor region against the charge source region, a signal corresponding to the memory position is taken out.

Reference is made, by way of example, to the accompanying drawings, in which:—

Figures 1 and 2 are, respectively, a schematic plan view and a schematic cross-sectional view taken along the line X—X in Figure 1, of a semiconductor device embodying this invention in the course of production;

Figures 3 and 4 are, respectively, a schematic plan view and a schematic cross-sectional view taken along the line Y—Y in Figure 3, of a completed semiconductor device embodying the present invention;

Figure 5 is a graph representing the relationship between the capacity (C) of a metal-insulator-semiconductor layer configuration and the voltage (V) applied between the metal layer and the semiconductor layer;

Figure 6 is a schematic wiring diagram of a random access memory device embodying this invention; and

Figure 7 is a time chart of signal pulses employed for writing information into and reading information out from a random access memory device embodying this invention.

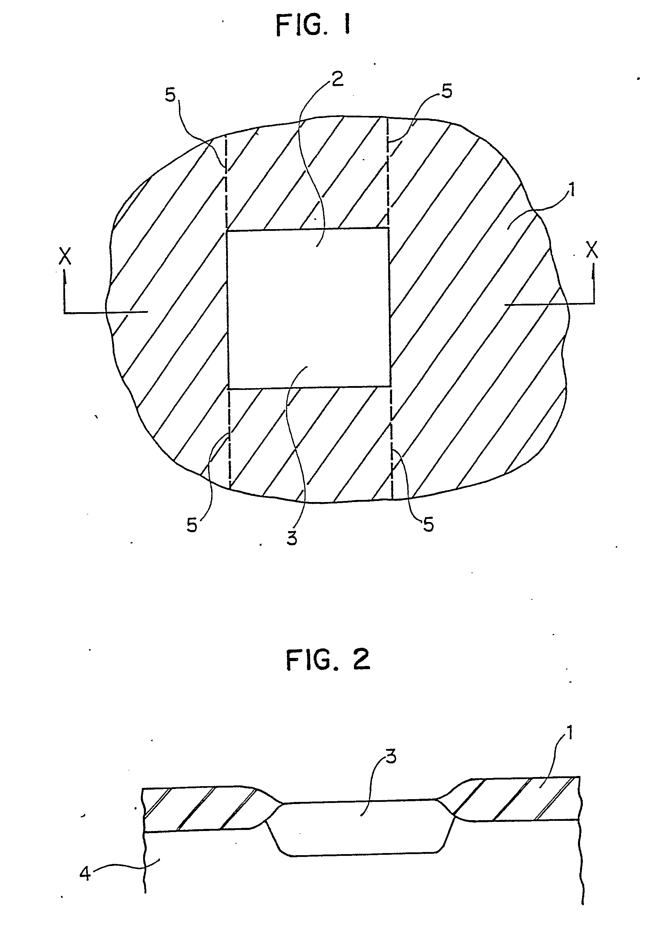

With reference to Figures 1 to 4, an example of steps for production of, and the arrangement and configuration of, each element of a random access memory cell embodying this invention will be described below, on the assumption that the random access memory cell is produced in an N-type silicon semiconductor substrate.

For a first part of a production process there are two alternatives. Therefore, the steps involves in each of the two alternatives will be separately described.

A first step of a first alternative is to grow a silicon nitride (Si$_3$N$_4$) layer over the entire upper surface of the N-type silicon substrate.

A second step is to employ a photolithography process for removing the silicon nitride layer from the substrate surface excepting a part thereof on an area where a charge storage region is to be produced.

A third step is to selectively oxidize the substrate employing the remaining silicon nitride layer parts as a mask. As a result, a field silicon dioxide (SiO$_2$) layer with a approximate thickness of 1 to 2 micro meters is produced on the top surface of the substrate except in the area where a charge storage region is to be produced.

After removing the silicon nitride mask employed for selective oxidation as described above, an ion implantation process is employed to introduce acceptor impurities such as boron (B) selectively in a specific area of the substrate to produce a charge source (and charge storage) region. This is a fourth step.

A first step of a second alternative is to employ a photolithography process to produce an opening in a photo resist film coated on a substrate. The opening is produced on an area where a charge source (and charge storage) region is to be produced.

A second step is to employ an ion implantation process to introduce acceptor impurities such as boron (B) employing the photo resist film as a mask.

After coating a silicon nitride layer over the entire surface of the substrate, a so-called lift off process is employed to remove the silicon nitride layer together with the photo resist film from the area of the substrate into which impurities were not introduced during the above-described ion implantation process. This is a third step.

A fourth step is to produce a field silicon dioxide layer 1 on the area of the substrate from which the silicon nitride layer together with the photo resist film was removed during the above-described step. The field silicon dioxide layer is formed by selective oxidation using the remaining silicon nitride layer parts as a mask. Therefore, the field silicon dioxide layer is not fabricated on the area of the substrate into which the impurities were introduced. Thereafter, the silicon nitride layer is entirely removed.

Figures 1 and 2 respectively show a plan view and a cross-sectional view of a substrate, after a fourth step has been completed. In these Figures 1 is a field silicon dioxide layer grown on an N-type silicon substrate 4, 3 is a P-type region which constitutes a charge source region.

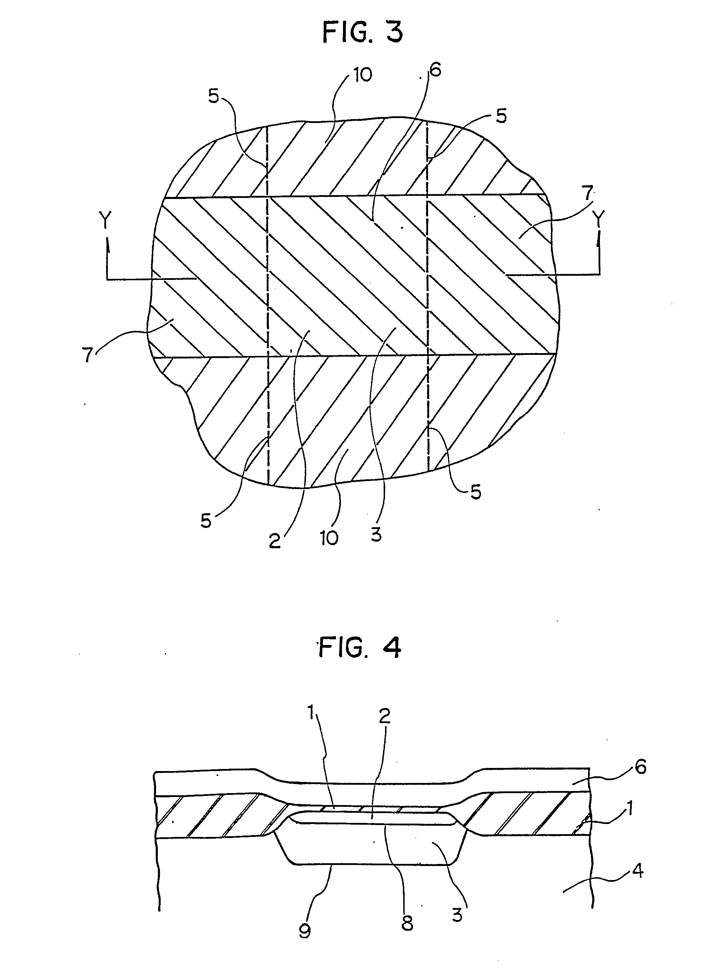

It is to be noted that broken lines 5 indicate external boundaries of buried conductor zones 10 (see Figure 3) which connect the charge source region 3 and a terminal (not shown) or connect charge source regions 3 with one another in a case in which a plurality of charge source regions are provided on one chip. The buried conductor zones 10 are preferably formed as P-type regions which are united with the charge source regions 3 as a continuous belt. It is to be further noted that a charge storage region 2 and the charge source region 3 overlap each other in the plan view.

Following the first part of the production process, a fifth step is to introduce donor impurities such as arsenic (As) only to a selected surface portion of the charge source region 3 to a depth of 1—2 µm, preferably employing an ion implantation process. As a result, a P-N junction is formed above selected regions of the charge source region 3.

A sixth step is to form a silicon dioxide layer on the entire wafer or substrate surface with an approximate thickness of 100 nm. This silicon dioxide layer is shown in Figure 4 as a reference numeral 1'.

Referring to Figures 3 and 4, a seventh step is to form a conductor layer 6 on the silicon dioxide layers 1 and 1' and selectively at an area above the charge storage region 2 on the charge source region 3 and at conductor zones which connect the conductor layer 6 and a terminal (not shown) or connect conductor layers 6 with one another in a case in which a plurality of charge source regions are provided on one chip. 7 indicates these conductor zones. 8 and 9 are P-N junctions formed respectively between the P-type charge source region 3 and the N-type charge storage region 2 and the P-type charge source region 3 and the N-type silicon substrate.

Referring again to Figure 4, an example of the functions of a semiconductor device embodying this invention will be described below. As described earlier, a capacitor is constituted by the charge source region 3 and the conductor region 6, which are spaced apart by a thin dielectric layer 1'. Since the N-type charge storage region 2 is interleaved or interposed between the P-type charge source region 3 and the thin dielectric layer 1', a pulse signal with a positive voltage applied to the P-type charge source region 3 during a period in which a negative voltage is applied to conductor region 6, leads to retention of some quantity of positive charge in or leads to transfer of negative charge from charged storage region 2, and as a result of the presence of P-N junction 8 the more positive charge is confined in the N-type charge storage region 2. This confined more positive charge decreases the capacity of the capacitor. This means the above-mentioned positive pulse signal is memorised in the capacitor in the form of decreased capacity. This variation in capacity is allowed to correspond either to digital information such as "1" or "0", or to analog information. The information memorised in the capacitor is read out by applying a positive voltage pulse to the conductor layer 6 and a negative voltage pulse to the charge source region 3 hence detecting the capacitance charge through the output terminal, by detecting the signal current allowed to flow into the output terminal located at the end of the conductor region 6 as a result of the increased impedance of a bypass circuit which includes the capacitor.

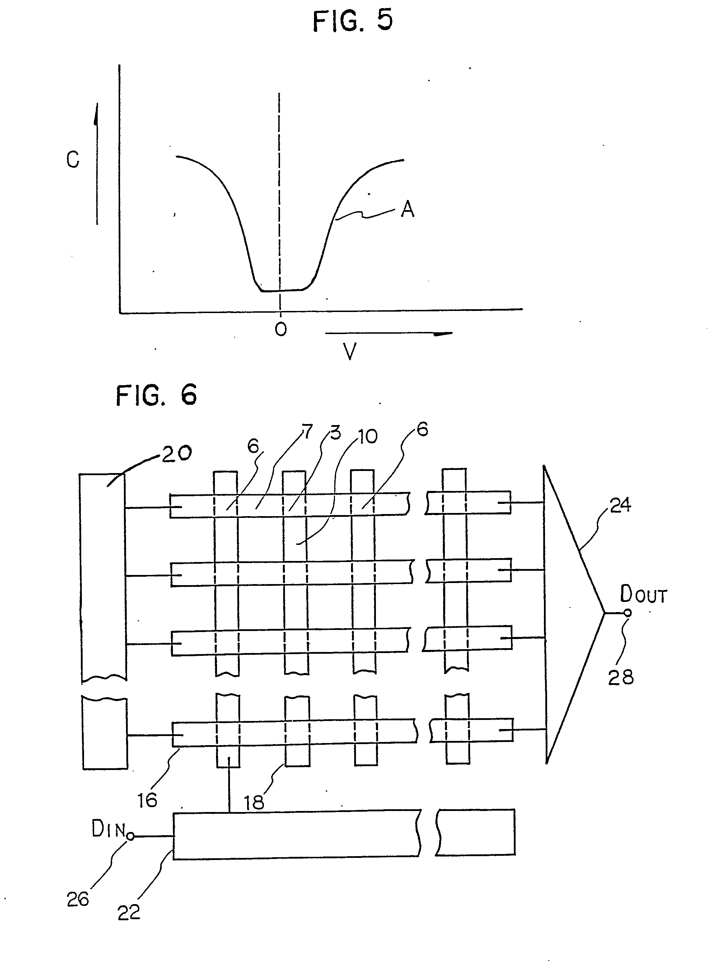

This memory function is based on the following principals. In the metal-insulator-semiconductor layer configuration, the capacity (C) varies with the voltage (V) applied between the metal and the semiconductor depending on the charge redistribution as illustrated by curve A of Figure 5. Firstly, when the voltage (V) is of a large negative potential, an inversion layer occurs around the interface between the insulator and the semiconductor. As a result, the capacity (C) between them is large. Secondly, when the voltage (V) lies within intermediate values in the neighborhood of 0 V (zero volt), a depression (depletion) layer spreads around the interface. As a result, capacity (C) is small. Thirdly, when the voltage (V) is of a large positive potential, an accumulation layer occurs around the interface. As a result, capacity (C) is again large. This means that the capacity (C) depends on the charge amount available around the interface (between insulator and semiconductor). Therefore, if some quantity of charge can be confined in the neighborhood of the interface, namely in surface regions, the capacity (C) of the capacitor can be controlled. Further, if some quantity of charge to be confined in the neighborhood of the surface can be provided by a pulse signal, the pulse signal is memorised in the form of a change in capacity of the capacitor.

In the layer configuration shown in Figure 4, a positive pulse signal, for example, which is applied to the charge source region 3 against or opposite or beneath the conductor layer 6 (positive with respect to layer 6) supplies some quantity of charge to the charge storage region 2, and the charge is confined in the charge storage region 2 as a result of the presence of the P-N junction 8. This readily changes the capacity of the capacitor constituted by the charge storage region 2 and the dielectric layer 1' and the pulse signal is memorised in the capacitor. This means that the layer configurations shown in Figure 4 functions as a memory cell. As described earlier, other means are available for writing information into the memory. When reading information, a positive pulse signal, for example, is applied to the conductor layer 6 against or beneath an output terminal (not shown) (at an opposite end of the conductor layer to the output terminal), while a positive voltage, for example, is applied to the conductor layer 6 against the charge source region 3 (positive with respective to the charge source region 3). Since the capacity (C) of the capacitor is small in a case in which an amount of charge representing information has been memorised in the memory cell, the impedance of the capacitor is large. Therefore, the positive signal applied to the conductor layer 6 against the charge source region 3 goes out of the output terminal (not shown) in the form of current. As described earlier, other means are available for reading information memorized in the memory cell.

From the above description, it will be clear that a memory cell consisting of only one capacitor of which the capacity can be changed by a pulse signal is provided in accordance with an embodiment of this invention. It is to be noted that since the memory cell consists of only one capacitor, it requires an extremely small amount of chip area. Moreover, it is noted that the memory cell has a non destructive read-out characteristic.

When the above mentioned layer configuration includes a transparent conductor layer 6 it can function as a photo electric transducer or an image sensor unit, because irradiaton of the P-N junction between the charge source region 3 and the charge storage region 2 with light causes generation of some quantity of positive and negative charge pairs, one type of which is stored in the charge storage region 2, as a result changing the capacity of the capacitor. This is the same function as that in which a piece of electric signal information is memorized. Therefore, the layer configuration can provide a photo electric transducer or an image sensor unit. The advantages of the image sensor unit are the same as those of the memory cell described earlier. Namely, smaller chip area requirement and non-destructive read out are major advantages.

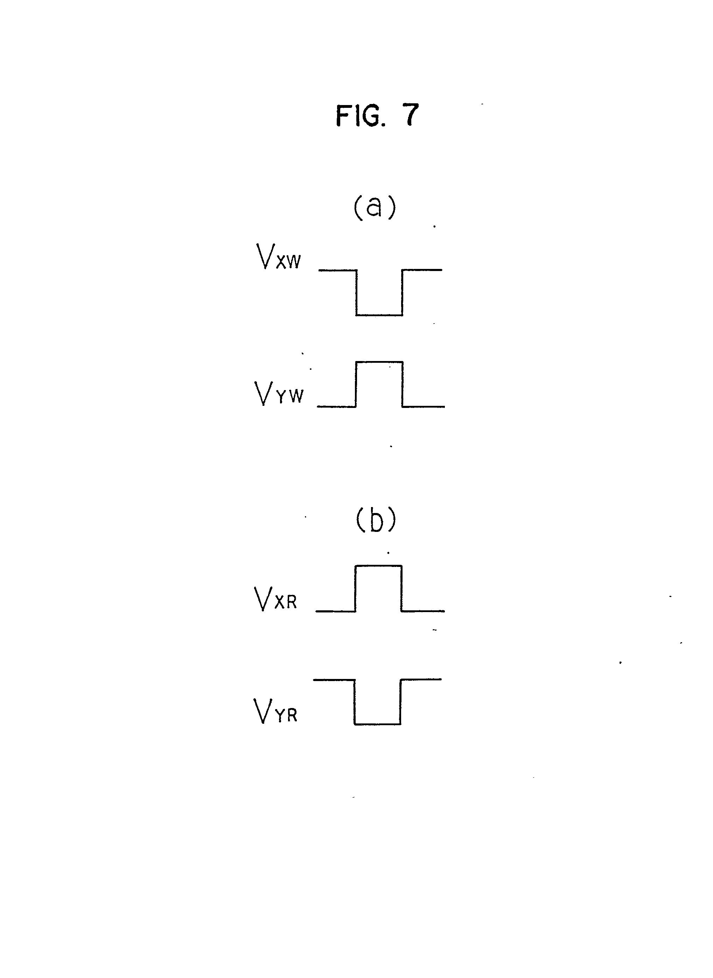

With reference to Figures 6 and 7, the wiring of and functioning of a random access memory device embodying this invention which utilizes a plurality of memory cells having a layer configuration as shown in Figures 3 and 4 will be described below.

Referring to Figures 3 and 6, the plurality of memory cells constitute a matrix. Looking downwardly from above, the conductor layers 6 and conductor zones 7 are placed one after the other to constitute respective rows which in this case are bit lines 16. Inside a chip of the device, charge source regions 3 and buried conductor regions 10 are placed one after the other, to constitute respective columns which in this case are word lines 18. 20 is a Y-address circuit which selects a specific bit line 16. 22 is an X-address circuit which selects a specific word line 18. Input signals are applied to the X-address circuit 22 through a signal input terminal 26 to supply charges to addressed charge storage regions 2. The information is read out from signal output terminal 28 through a sense amplifier 24.

Referring to Figures 7(a) and 7(b), the X-address circuit 22 and the Y-address circuit 20 respectively supply a positive (or negative) voltage signal (depending on the doping type of the charge source region) $(V_{XW})$ and a negative (or positive) voltage signal $(V_{XW})$, for example, to write a piece of information in a memory cell located at a cross point of a selected word line 18 and a selected bit line 16. On the other hand, the X-address circuit 22 and the Y-address circuit 20 respectively supply a negative (or positive) voltage signal $(V_{XR})$ and a positive (or negative) voltage signal $(V_{YR})$, for example, to read a piece of information memorized in the memory cell located at the cross point of a selected word line 18 and a selected bit line 16.

From the above description, it will be clear that a random access memory device embodying this invention can enjoy various advantages, including non-destructive read out, less chip surface area requirement and a much simplified control circuit.

In a quite similar manner, an image sensor embodying this invention an enjoy each of the various advantages referred to above.

The capacity of a capacitor constituted in a metal-insulator-semiconductor layer configuration varies depending on the quantity of electric charge staying in the neighborhood of the interface between the insulating layer and the semiconductor layer. The interleave or interposition of a thin semiconductor layer between the insulating layer and the semiconductor layer to form a P-N junction therebetween is effected to confine some quantity of electric charge in the thin semiconductor layer, causing an effect which is used to regulate the capacity of the capacitor in an embodiment of this invention. When the quantity of electric charge confined in the thin semiconductor layer is supplied in the form of an electric pulse signal, the signal can be memorized in the form of capacity. In an embodiment of this invention a layer configuration of a conductor, an insulator and a semiconductor including a P-N junction therein fabricated on a substrate (either of semiconductor or insulator) in which the layers are isolated, functions as a memory cell which consists of only one capacitor and which requires an extremely small chip area and provides for non destructive read out. The same layer configuration is effective in another embodiment of this invention to function as a photo electric transducer or an image sensor unit, when the conductor layer is fabricated as a transparent conductor.

**Claims**

1. A semiconductor device having:
   a substrate (4) of a material which is either an insulator or a semiconductor of one conductivity type;
   a matrix array of memory cells, each memory cell comprising:—
   a semiconductor charge source region (3) formed on a selected portion of said substrate (4) and, in a case in which the substrate is of a semiconductor of one conductivity type, having a conductivity type different from that of the substrate,
   a semiconductor charge storage region (2), having a conductivity type different from that of said charge source region, formed on a selected portion of said charge source region (3), and being electrically floating on said substrate, a P-N junction (8) being formed between the charge storage region (2) and the charge source region (3),
   an insulating layer (1) formed on said charge storage region (2) and the top surface of said charge source region (3) which is not covered by said charge storage region (2), and
   a conductor layer (6) formed on said insulating layer (1);
   bit lines, each constituted by the respective conductor layers (6) of a plurality of the memory cells arranged one after another along a respective row of the matrix array, together with conductor zones (7) connecting those conductor layers; and
   word lines, each constituted by the respective charge source regions (3) of a plurality of the memory cells arranged one after another along a respective column of the matrix array, together with buried conductor regions (10) connecting those charge source regions.

2. A device as claimed in claim 1, wherein, in each word line, the buried conductor regions (10) are regions united with the charge source regions (3), being of the conductivity type different from that of the substrate in a case in which the substrate is of a semiconductor of one conductivity type.

3. A device as claimed in claim 1 or 2, wherein the conductor layer (6) of each memory cell is formed of a transparent conductive material, such that the device has a photo-electric transducer function or an image sensor function.

4. A device as claimed in claim 3, wherein each memory cell provides a sensor cell of the device.

5. A device as claimed in any preceding claim, wherein, in each memory cell, the insulating layer (1) comprises a thin layer part on the semiconductor charge storage region (2) and a thick field oxide layer around the semiconductor charge storage region.

6. A device as claimed in claim 5, wherein, in a case in which the substrate is of semiconductor of one conductivity type, the thick field oxide layer part is formed by selective oxidation of the substrate.

**Revendications**

1. Dispositif semiconducteur possédant:

un substrat (4) fait d'un matériau qui est un isolant ou un semiconducteur d'un premier type de conductivité;

un réseau matriciel de cellules de mémoire, chaque cellule de mémoire comprenant:

une région (3) source de charges semiconductrice formée sur une partie sélectionnée dudit substrat (4) et, dans le cas où le substrat est fait d'un semiconducteur d'un premier type de conductivité, possédant un type de conductivité différent de celui du substrat,

une région (2) d'emmagasinage de charges semiconductrice possédant un type de conductivité différent de celui de ladite région source de charges, formée sur une partie sélectionnée de ladite région (3) source de charges et se trouvant en flottement électrique sur ledit substrat, une jonction P-N (8) étant formée entre la région (2) d'emmagasinage de charges et la région (3) source de charges,

une couche isolante (1) formée sur ladite région (2) d'emmagasinage de charges et la surface supérieure de ladite région (3) source de charges qui n'est pas recouverte par ladite région (2) d'emmagasinage de charges, et

une couche conductrice (6) formée sur ladite couche isolante (1);

des lignes de bit constituées chacune par les couches conductrices (6) respectives des différentes cellules de mémoire placées les unes après les autres le long d'une rangée respective du réseau matriceel, en même temps que des zones conductrices (7) reliant ces couches conductrices; et

des lignes de mot constituées chacune par les régions (3) sources de charges respectives des différentes cellules de mémoire placées les unes après les autres le long d'une colonne respective du réseau matriciel, en même temps que des régions conductrices enterrées (10) reliant ces régions sources de charges.

2. Dispositif selon la revendication 1, où, dans chaque ligne de mot, les régions conductrices enterrées (10) sont des régions unies aux régions (3) sources de charges, étant d'un type de conductivité différent de celui du substrat dans le cas où le substrat est fait d'un semiconducteur d'un premier type de conductivité.

3. Dispositif selon la revendication 1 ou 2, où la couche conductrice (6) de chaque cellule de mémoire est formée d'un matériau conducteur transparent, si bien que le dispositif possède une fonction de transduction photo-électrique, ou une fonction de détection d'image.

4. Dispositif selon la revendication 3, où chaque cellule de mémoire forme une cellule de détection du dispositif.

5. Dispositif selon l'une quelconque des revendications précédentes, où, dans chaque cellule de mémoire, la couche isolante (1) comprend une partie de couche mince se trouvant sur la région (2) d'emmagasinage de charges semiconductrice et une couche d'oxyde de champ épaisse située autour de la région d'emmagasinage de charges semiconductrice.

6. Dispositif selon la revendication 5, où, dans le cas où le substrat est fait d'un semiconducteur d'un premier type de conductivité, la partie de couche d'oxyde de champ épaisse est formée par oxydation sélective du substrat.

**Patentansprüche**

1. Halbleitervorrichtung mit:

einem Substrat (4) aus einem Material, welches entweder ein Isolator oder ein Halbleiter von einer Leitfähigkeitsart ist;

einer Matrixanordnung von Speicherzellen, von denen jede Speicherzelle umfaßt:—

einen Halbleiter-Ladungssourcebereich (3), welcher auf einem ausgewählten Abschnitt des genannten Substrats (4) gebildet ist und, falls das Substrat aus einem Halbleitermaterial von einer Leitfähigkeitsart besteht, eine Leitfähigkeitsart hat, die von derjenigen des Substrats unterschiedlich ist,

einen Halbleiter-Ladungsspeicherbereich (2), welcher eine Leitfähigkeitsart hat, die von derjenigen des genannten Ladungssourcebereiches verschieden ist, der auf einem ausgewählten Abschnitt von dem genannten Ladungssourcebereich (3) gebildet ist und elektrisch schwebend auf dem genannten Substrat ist, wobei ein P-N-Übergang (8) zwischen dem Ladungsspeicherbereich (2) und dem Ladungssourcebereich (3) gebildet ist,

eine Isolierschicht (1), die auf dem genannten Ladungsspeicherbereich (2) und der oberen Oberfläche des genannten Ladungssourcebereichs (3) geformt ist, die nicht von dem genannten Ladungsspeicherbereich (2) bedeckt ist, und

eine Leiterschicht (6), die auf der isolierenden Schicht (1) gebildet ist;

Bitleitungen, die jeweils von entsprechenden Leiterschichten (6) einer Vielzahl von Speicherzellen gebildet werden, die eine hinter der anderen längs einer entsprechenden Reihe einer Matrixanordnung angeordnet sind, zusammen mit Leiterzonen (7), welche diese Leiterschichten verbinden; und

Wortleitungen, die jeweils durch die entsprechenden Ladungssourcebereiche (3) von einer Vielzahl von den Speicherzellen, die eine hinter der anderen längs entsprechenden Spalten der Matrixanordnung angeordnet sind, gebildet werden, zusammen mit vergrabenen Leiterbereichen (10), welche jene Ladungssourcebereiche verbinden.

2. Vorrichtung nach Anspruch 1, bei welcher in jeder Wortleitung die vergrabenen Leiterbereiche (10) Bereiche sind, welche mit den Ladungssourcebereichen (3) vereinigt sind, die von einer Leitfähigkeitsart sind, die von derjenigen des Substrates verschieden ist, falls das Substrat aus einem Halbleiter von einer Leitfähigkeitsart besteht.

3. Vorrichtung nach Anspruch 1 oder 2, bei welcher die Leiterschicht (6) jeder Speicherzelle aus einem transparenten leitenden Material besteht, so daß die Vorrichtung eine fotoelektrische Wandlerfunktion oder eine Bildsensorfunktion hat.

4. Vorrichtung nach Anspruch 3, bei welcher jede Speicherzelle eine Sensorzelle einer Vorrichtung bildet.

5. Vorrichtung nach einem der vorhergehenden Ansprüche, bei welcher in jeder Speicherzelle die isolierende Schicht (1) einen dünnen Schichtteil auf dem Halbleiter-Ladungsspeicherbereich (2) und eine dicke Feldoxidschicht um den Halbleiter-Ladungsspeicherbereich herum bildet.

6. Vorrichtung nach Anspruch 5, bei welcher, falls das Substrat aus Halbleiter der einen Leitfähigkeitsart besteht, der dicke Feldoxidschichtteil durch selektive Oxidation des Substrats gebildet ist.

## FIG. 1

## FIG. 2

## FIG. 3

## FIG. 4

## FIG. 5

## FIG. 6

# FIG. 7

## (a)

$V_{XW}$

$V_{YW}$

## (b)

$V_{XR}$

$V_{YR}$